# EUROPÄISCHE PATENTSCHRIFT

(11) **EP 2 734 594 B1**
(45) Veröffentlichungstag und Bekanntmachung des Hinweises auf die Patenterteilung: **27.04.2016**
(21) Anmeldenummer: 12733735.0
(22) Anmeldetag: 11.07.2012
(51) Int. Cl.: B29C 65/76, C09J 5/00, C09J 183/04, H01L 21/683

(54) **TEMPORÄRE VERKLEBUNG VON CHEMISCH ÄHNLICHEN SUBSTRATEN**
TEMPORARY ADHESION OF CHEMICALLY SIMILAR SUBSTRATES
COLLAGE TEMPORAIRE DE SUBSTRATS CHIMIQUEMENT SIMILAIRES

(30) Priorität: 22.07.2011 DE 102011079687
(43) Veröffentlichungstag der Anmeldung: 28.05.2014
(73) Patentinhaber: Wacker Chemie AG, 81737 München (DE)
(72) Erfinder: KÖLLNBERGER, Andreas, 84375 Kirchdorf (DE); ACHENBACH, Frank, 84359 Simbach (DE)
(74) Vertreter: Mieskes, Klaus Theoderich
(86) Internationale Anmeldenummer: PCT/EP2012/063601
(87) Internationale Veröffentlichungsnummer: WO 2013/013986

(56) Entgegenhaltungen:
- EP-A1- 1 510 553
- WO-A1-2006/093639
- WO-A1-2011/100030
- US-A- 5 312 855

## Beschreibung

Die vorliegende Erfindung betrifft die Verwendung eines Klebers, basierend auf vernetzbaren Siliconzusammensetzungen, für das temporäre Verkleben eines Siliziumwafers mit einem Siliziumträger. Der Begriff "temporäre Verklebung" bedeutet, dass zu einem gewünschten Zeitpunkt die Substrate wieder voneinander gelöst werden können. Die Klebeschicht verbleibt beim Lösen der Verbindung praktisch vollständig an einem der beiden Substrate, so dass kein oder sehr wenig Material der Klebeschicht durch mechanische oder chemische Methoden vom anderen Substrat nachträglich entfernt werden muss.

In industriellen Prozessen besteht die Forderung nach temporären Klebstoffen zwischen zwei chemisch ähnlichen Substraten, die sich nach Gebrauch spezifisch wieder von dem gewünschten Substrat lösen sollen. Dabei wird ein Adhäsionsriss zwischen einem Substrat und der Klebschicht bevorzugt. Bisher verwendete Formulierungen sind in der Lage, zwei ähnliche Substrate zu verkleben, ohne jedoch ein Substrat zu bevorzugen. Nach dem Stand der Technik können bisher die Haftkräfte nur über die Vorbehandlung des jeweiligen Substrats mit Hilfe von physikalischen oder chemischen Methoden gezielt eingestellt werden. Beispiele für physikalische Verfahren sind Schleifen der Oberfläche, UV-Bestrahlung, Beflammung, Corona- oder Plasmabehandlung. Bei derartigen Vorbehandlungsschritten wird die Oberfläche bzw. oberflächennahe Schicht des Substratmaterials aktiviert, d.h. es werden funktionelle, vorwiegend polare Gruppen geschaffen. Beispiele für chemische Verfahren sind die Vorbehandlung mit haftvermittelnden Additiven (auch Primern genannt) oder die Vorbehandlung mit Substanzen, die die Haftung verhindern (auch Release Agent genannt).

Besonders die Marktanforderungen von den Herstellern von Halbleiterbauteilen an die herzustellenden Chips verlangen immer dünnere Gesamthöhen. Eine Möglichkeit, die Gesamthöhe des Formbauteils zu verringern, ist es, die Wafer zu dünnen. Der Schleifprozess kann vor oder nach der Formsingulation ("Dicing") durchgeführt werden.

Durch die immer größer und dünner werdenden Wafer ist die strukturelle Festigkeit des Wafers verringert. Dadurch können die großen, dünnen Wafer bei der Bearbeitung mit den üblicherweise verwendeten Geräten und Materialien, wie z.B. den heute verwendeten "dicing tapes", aufgrund mangelnder mechanischer Unterstützung, brechen. Zudem können die bis zu 100 µm oder mehr herausragenden Waferstrukturen ("Bumps") durch die heute verwendeten Klebefilme (Tapes) nicht vollständig und hohlraumfrei umschlossen werden, so dass die verbleibenden Hohlräume beim Bearbeiten im Vakuum in der Regel zu einer Zerstörung oder Beeinträchtigung des dünnen Wafers führen.

Eine mögliche verfahrenstechnische Lösung für dieses Problem ist, den Wafer über eine temporäre Klebeschicht mit einem harten Substrat zu verkleben (beispielsweise mit einem anderen Wafer oder einem Waferträger wie z.B. Glas), um die mechanische Festigkeit zu erhöhen, anschließend die gewünschten Bearbeitungsprozesse durchzuführen, und abschließend den dann nur noch 10-100 µm dünnen Wafer wieder vom Substrat abzulösen. Das über den Klebstoff angebundene Substrat dient dabei als mechanische Verstärkung während der Schleif- und nachgeschalteten Bearbeitungsprozesse.

Die spätere Nachbearbeitung des gedünnten Wafers umfasst auch die Schaffung von Resiststrukturen durch Plasmaätzen und Prozesse wie beispielsweise Metallplattieren und Rückstandsreinigen.

Eine Möglichkeit, den Halbleiterwafer auf einem Träger zu fixieren, stellen sogenannte "Adhesive Tapes" dar. EP 0838086 B1 beschreibt ein Band aus einem thermoplastischen Elastomer-Block-Copolymer zur Verwendung für die Verarbeitung von Halbleiter-Wafern. Die begrenzte Elastizität des Materials führt jedoch zu Problemen bei der Verwendung von Wafern, die Oberflächenstrukturen aufweisen ("gebumpte Wafer"). Die thermoplastischen Eigenschaften des Materials führen außerdem zu einer verminderten Hitzestabilität, die für die, sich nach dem Dünnen des Wafers ("back-side grinding") anschließende, Rückseitenprozesse (Plasmaverfahren, CVD, ...) erforderlich ist.

WO 2009/003029 A2 beansprucht thermoplastische organische Polymere (Imide, Amidimide und Amidimide-Siloxane) für die Verwendung als temporärer Klebstoff zwischen einem Wafer und einem Carrier.

WO 2009/094558 A2 beschreibt die temporäre Verklebung eines Wafers und eines Carriers, wobei die Verklebung nicht über die gesamte Fläche erfolgt, sondern nur im Randbereich. Die Verklebung wird nach erfolgtem Schleifprozess und eventuellen Rückseitenprozessen, chemisch, photochemisch, thermisch oder thermo-mechanisch zerstört.

EP 0603514 A2 beschreibt eine Methode, um einen Halbleiterwafer zu dünnen, wobei das verwendete Klebstoffmaterial maximal für Temperaturen von 200 °C geeignet ist.

In der US-Anmeldung US2004/0121618 A1 wird ein Flüssigklebstoff, der für Spin-Coating-Prozesse geeignet ist, beschrieben, wobei dieser aus einem thermoplastischen Polyurethan, sowie Dimethylacetamide und Propylenglycolmonomethylether als Hauptkomponenten besteht.

EP 1089326 B1 beansprucht einen Träger für Wafer, der aus einem mit einer staubdichten Folie bedecktem Siliconelastomer besteht, wobei die Trennkraft zwischen der Folie und der Siliconschicht von 5 bis 500 g/25 mm (nach JIS K 6854) beträgt. Außerdem wird ein Verfahren zur Herstellung eines Wafer-Trägers beschrieben.

Die WO 2004/051708 A2 beschreibt ein Verfahren für die Bearbeitung eines Wafers, wobei zwischen der Vorderseite des Wafers und der Trägerschicht (=Klebstoff) eine Trennschicht aufgebracht wird. Die Herstellung dieser Trennschicht stellt einen zusätzlichen Schritt in der Produktionskette dar, was zu verlängerten Bearbeitungszeiten und zu höheren Produktionskosten führt.

Das Hauptproblem besteht darin, dass ähnliche Materialien wie in diesem Fall der vorher prozessierte Siliziumwafer, der an seiner Oberfläche auch andere Materialien als Silizium enthalten kann, mit einem Träger, der ebenfalls aus Silizium besteht, zum einen mit einer Klebeschicht fest verbunden werden soll, zum anderen jedoch nach den in der Waferbearbeitung üblichen Schritten wie beispielsweise Wafer-Schleifen bzw. - Dünnen, Beschichten, etc. möglichst einfach und selektiv an der Waferoberfläche getrennt werden soll.

Die bisher nach dem Stand der Technik verwendeten Systeme sind für bestimmte Bearbeitungsverfahren wie beispielsweise die thermische Abscheidung von Siliziumdioxid oder Hochtemperaturdielektrika unbefriedigend, da die verwendeten Polymere eine nur unzureichende Hochtemperaturbeständigkeit besitzen. Neben der notwendigen Temperaturbeständigkeit bis über 300°C sind zudem die richtige Balance und Optimierung der Formulierung in Bezug auf die mechanischen Parameter (beim Rückschleifen des Wafers), die chemische Beständigkeit gegenüber verschiedenen in der Chipbearbeitung üblichen Chemikalien, die minimale Freisetzung von flüchtigen Nebenprodukten (Kontaminationsgefahr), und die Viskosität des nicht ausgehärteten Klebstoffes (beim Auftrag auf den Wafer) wichtige Ziele bei der Entwicklung eines geeigneten Materials im betrachteten Sandwich System.

Es besteht daher besonders in der Halbleiterindustrie ein Bedarf an einem selektiv haftenden Klebstoff für ein temporäres Verkleben von zwei chemisch ähnlichen Substraten. Der Klebstoff muss für den Auftrag mit einem industriell praktikablem Verfahren (zum Beispiel Spritzbeschichten, Drucken, Tauchen, Rotationsbeschichten) geeignet sein, und sich zum gewünschten Zeitpunkt über geeignete Verfahren rückstandsfrei vom gewünschten Substrat lösen lassen. Zudem soll der Klebstoff neben der stützenden Verbindung (= harte Verbindung zum Substrat) auch gewisse elastische Eigenschaften aufweisen.

Diese Forderungen gelten insbesondere für Wafer-Bonding-Verfahren. Die Klebereigenschaften sollen die Bearbeitung des Wafers ermöglichen, ohne dass dieser bricht oder beschädigt wird und zudem auch die Frontstrukturen des Wafers unterstützend umschließen können.

Überraschenderweise wurde festgestellt, dass diese Aufgabe durch die erfindungsgemäße Verwendung eines Klebers gelöst wird, d.h. ein temporäres und zugleich selektives Verkleben eines Siliziumwafers mit einem Siliziumträger ohne Vorbehandlung mit einem Kleber möglich ist,
wobei der Kleber eine vernetzbare Siliconzusammensetzung ist, die dadurch gekennzeichnet ist, dass sie mindestens einen Haftregulierer (A) enthält, der ausgewählt wird aus der Gruppe enthaltend Haftvermittler oder Trennmittel oder deren Kombination,
mit der Maßgabe, dass der Haftregulierer (A) in solchen Mengen enthalten ist, dass die Haftkraft bzw. Schälfestigkeit zwischen dem ausgehärteten Kleber und einem Substrat um mindestens 0,5 N/mm größer ist als die Haftkraft zwischen dem ausgehärteten Kleber und dem anderen Substrat, gemessen nach **DIN ISO 813,** und sich der ausgehärtete Kleber beim Lösen der Verklebung nur von einem Substrat auf mindestens 80 % der Fläche adhäsiv lösen lässt.

Die vernetzbare Siliconzusammensetzung wird bevorzugt ausgewählt aus der Gruppe enthaltend kondensationsvernetzende, additionsvernetzende und peroxidisch vernetzende Siliconzusammensetzungen.

Besonders vorteilhaft ist, dass die erfindungsgemäße Verwendung von vernetzbaren Siliconzusammensetzungen als Kleber den Aufbau eines selektiv haftenden Verbundes zwischen zwei chemisch ähnlichen Substraten, einem Siliziumwafer mit einem Siliziumträger ermöglicht, wobei auf eine Vorbehandlung der zu verklebenden Substrate verzichtet werden kann.

Die erfindungsgemäße Verwendung der vernetzbaren Siliconzusammensetzungen als Klebstoff ermöglicht ein temporäres Wafer-Bonding-Verfahren, ohne dass der Wafer bricht oder beschädigt wird. Ein Auftrag mit industriellen Verfahren (zum Beispiel Spritzbeschichten, Drucken, Tauchen, Rotationsbeschichten) ist problemlos möglich, ebenso ein rückstandsfreies Lösen vom Wafer zum gewünschten Zeitpunkt. Zudem zeigt die Klebeverbindung die gewünschten mechanischen Eigenschaften aus stützender Verbindung (= harte Verbindung zum Substrat) und Elastizität, und sie kann die Frontstrukturen des Wafers unterstützend umschließen.

Als stoffliche Basis für den erfindungsgemäß verwendeten Kleber können grundsätzlich alle, auf beliebigen Vernetzungsmechanismen beruhende härtbare Siliconzusammensetzungen dienen. Die Härtung der Siliconzusammensetzung, die diese in ein Siliconelastomer überführt, kann beispielsweise durch Einwirkung elektromagnetischer Strahlung (z.B. Mikrowellen, UV-Licht, Röntgen- oder Gammastrahlung) oder hochenergetischer Teilchen (z.B. Elektronen, Protonen, Alphateilchen) erfolgen. Vorzugsweise erfolgt die Härtung der Siliconzusammensetzung durch die dem Fachmann wohlbekannte Kondensations-, Additions- oder peroxidische Vernetzung, doch auch die in der industriellen Praxis weniger geläufigen Vernetzungsmechanismen sollen umfasst werden, z.B. Vernetzung mittels Dehydrokondensation, Thiol-En-Reaktion, "Click"-Reaktion. Handelt es sich bei der Siliconzusammensetzung um eine thermoplastische Siliconzusammensetzung, so kann das Verkleben der Substrate durch vorheriges Aufschmelzen der Siliconmasse bewerkstelligt werden, d.h., in diesem Fall soll unter "Härtung" das Abkühlen der Siliconmasse unter den Schmelzpunkt derselben verstanden werden (physikalische Vernetzung). Auch kann die Härtung durch eine Kombination der voranstehenden Vernetzungsmöglichkeiten erfolgen, beispielsweise durch UVinitiierte Platin-katalysierte Hydrosilylierungsreaktion.

Die mechanischen Kennwerte des ausgehärteten Klebers (Härte, Modul, Weiterreißwiderstand, Reißfestigkeit, Rückprallelastizität) bewegen sich dabei in den dem Stand der Technik bekannten Bereichen. Der erfindungsgemäße Kleber kann, je nach Vernetzungssystem, als ein- oder mehrkomponentige Formulierung vorliegen, wobei die Viskosität der Formulierung dem Prozess der Auftragung (Bsp.: Spin-Coating, Spritzguss, etc) angepasst wird und sich in den dem Stand der Technik bekannten Bereichen bewegt. Als bevorzugt wird der Bereich von 0,01 - 100 Pa•s und besonders bevorzugt der Bereich von 0,1 bis 10 Pa•s angesehen.

Als kondensationsvernetzende Siliconzusammensetzungen sind alle bisher im Stand der Technik bekannten Siliconzusammensetzungen geeignet. Typische Vertreter dieser Stoffgruppe sind die unter den Bezeichnungen RTV-1 (Room Temperature Vulcanising; 1-komponentig) und RTV-2 (2-komponentig) in der Fachliteratur zu findenden kondensationsvernetzenden Siliconmassen. RTV-2 Massen enthalten in einer der Komponenten typischerweise wenigstens ein Organopolysiloxan mit endständigen Silanolgruppen sowie weitere Bestandteile wie Füllstoffe und Weichmacher. Die zweite Komponente (der Härter) enthält ein Vernetzersilan oder - siloxan in Kombination mit einem die Kondensationsreaktion beschleunigenden Katalysator sowie ggf. weiteren Bestandteilen wie Weichmachern. Als Vernetzersilan bzw. -siloxan finden vor allem die über mindestens drei hydrolysierbare Reste verfügenden Silane und Siloxane Verwendung. Bevorzugt sind tri- oder tetrafunktionelle Alkoxysilane, deren Teilhydrolysate oder Alkoxysiloxane. Als effektive Kondensationskatalysatoren haben sich zinnorganische Verbindungen, beispielsweise Dialkylzinndicarboxylate und Zinn(II)dicarboxylate, und Organotitanverbindungen bewährt. Die kondensationsvernetzenden RTV-1 Massen, die bei Zutritt von Luftfeuchtigkeit unter Abspaltung eines Hydrolyseproduktes zu einem Siliconelastomer aushärten, basieren auf der Möglichkeit, silanolendständige Organopolysiloxane mit einem mehrere hydrolysierbare Gruppen enthaltenden Vernetzer endblockieren zu können, ohne zugleich eine Vernetzung herbeizuführen. Als Vernetzer können alle über mindestens drei hydrolysierbare Gruppen verfügenden Silane oder deren Teilhydrolysate eingesetzt werden. Entsprechend der Art der hydrolysierbaren Gruppe unterscheidet man beispielsweise Acetoxy-, Oxim-, Alkoxy-, Isoprenoxy-, Amid-, Amin- und Aminoxy-Vernetzungssysteme, die unter Abspaltung von Essigsäure, Oxim, Alkohol, Aceton, Amid, Amin oder Hydroxylamin vernetzen. Um eine ausreichend hohe Vernetzungsgeschwindigkeit zu erzielen, enthalten die meisten RTV-1 Massen einen Kondensationskatalysator, wobei zinnorganische und titanorganische Verbindungen bevorzugt eingesetzt werden.

Als additionsvernetzende Siliconzusammensetzungen sind alle bisher im Stand der Technik bekannten Siliconzusammensetzungen geeignet. Im einfachsten Fall enthalten sie wenigstens ein Organopolysiloxan mit wenigstens zwei aliphatisch ungesättigten Gruppen im Molekül (z.B. Si-gebundene Vinylgruppen), sowie wenigstens ein Organohydrogenpolysiloxan mit zwei oder mehr SiH Gruppen im Molekül und wenigstens einen die Anlagerung von Sigebundenen Wasserstoff an aliphatische Mehrfachbindungen fördernden Katalysator, der auch als Hydrosilylierungskatalysator bezeichnet wird. Bevorzugte Hydrosilylierungskatalysatoren sind Verbindungen des Platins, obgleich beispielsweise auch Rh-, Pd- und Ru-Komplexe eine hohe katalytische Aktivität aufweisen. Ein besonders bevorzugter Pt-Katalysator ist der Karstedt-Katalysator, ein Pt(0)-Divinyltetramethyldisiloxan-Komplex. Weitere Bestandteile additionsvernetzbarer Siliconmassen umfassen z.B. Füllstoffe, Inhibitoren (zur Einstellung einer zweckmäßigen Verarbeitungszeit und Vernetzungsgeschwindigkeit), Pigmente, Haftvermittler, Hitzestabilisatoren und dergleichen.

Als peroxidisch vernetzende Siliconzusammensetzungen sind alle bisher im Stand der Technik bekannten peroxid-induzierten radikalisch vernetzenden Siliconzusammensetzungen geeignet. Im einfachsten Fall enthalten sie wenigstens ein Organopolysiloxan mit mindestens 2 vernetzungsfähigen Gruppen pro Molekül wie beispielsweise Methyl- oder Vinylgruppen und wenigstens ein geeignetes organischen Peroxid.

Die erfindungsgemäß verwendeten Kleber enthalten Haftregulierer (A) in Mengen von vorzugsweise 0,01 bis 10 Gew%, bevorzugt 0,1 bis 5 Gewichtsprozent und besonders bevorzugt 0,5 bis 3 Gewichtsprozent.

Als Haftregulierer (A) wird ein **Trennmittel** eingesetzt, so können prinzipiell alle Fettsäurenester gesättigter oder ungesättigter Fettsäuren verwendet werden.

Beispiele für geeignete Fettsäureester sind Methyl-, Ethyl-, Propyl-, Butyl-, Pentyl-, Hexyl-, Heptyl-, Octyl-, Nonyl-, Decyl-, Dodecyl-, Tetradecyl-, Pentadecyl-, Hexadecyl-, Heptadecyl-, Octadecyl-, Nonadecyl-, Eicosyl-, Docosanyl-, Tetracosyl-, Hexacosyl-, Octacosyl- oder Triacontanylester der oben genannten Säuren. Auch ungesättigte oder verzweigte Fettsäureester sind für die Anwendung geeignet.

Die Fettsäureester enthalten zwischen 10 und 60 C-Atome und besonders bevorzugt zwischen 10 und 40 C-Atome

Die voranstehend als Haftregulierer (A) aufgeführten Trennmittel weisen ein jeweils spezifisches Löslichkeits- bzw. Mischbarkeitsverhalten in der als Kleber fungierenden vernetzbaren Siliconzusammensetzung auf. Dieses Verhalten kann in weiten Grenzen variieren. So kann der Haftregulierer im Kleber perfekt löslich sein, was einer auf molekularem Niveau homogenen Mischung entspräche. In der Regel wird der Haftregulierer (A) jedoch bedingt durch seine chemisch-physikalischen Eigenschaften eine verminderte Löslichkeit in der Klebermasse aufweisen, auch wenn sich dieser im makroskopischen Sinne homogen in die Klebermasse einmischen oder dispergieren lässt. Der Haftregulierer (A) kann auch vollständig unverträglich mit der Klebermasse sein, was sich z.B. durch rasch einsetzende Phasenseparation, Nichtdispergierbarkeit oder durch Ausblühungen bzw. Ausschwitzeffekte zu erkennen gibt. Je nach Grad der Unverträglichkeit des Haftregulierers (A) mit der Siliconmatrix des Klebers besteht also die Tendenz des Haftregulierers (A), an die Oberfläche der Siliconmasse zu migrieren oder auch eine mikrophasenseparierte Mischung auszubilden.

Überraschenderweise wurde gefunden, dass selbst im Fall einer homogenen Mischung bestehend aus Haftregulierer (A) und unvernetzter Siliconzusammensetzung (= Kleber), der Haftungsaufbau zwischen Kleber und dem 1. Substrat je nach Wahl des zugesetzten Haftregulierers (A) stärker oder schwächer eingestellt werden kann als der Haftungsaufbau zum 2. Substrat, selbst dann, wenn 1. und 2. Substrat chemisch-physikalisch völlig identisch sind. Es wurde beobachtet, dass die räumliche Lage des zu bildenden Verbundes aus Substrat 1, Kleberschicht und Substrat 2 eine wichtige Rolle für den Haftungsaufbau spielt. Ohne den Schutzumfang der Anmeldung einschränken zu wollen, liegt die Vermutung nahe, dass der Dichteunterschied zwischen der Siliconzusammensetzung und des verwendeten Haftregulierers (A) eine entscheidende Rolle einnimmt.

Für den Fall, dass es sich beim Haftregulierer (A) um ein Trennmittel, also eine Substanz handelt, die die Haftung vermindert, die Vermutung nahe, dass ein zugemischter Haftregulierer (A), die Haftung des oben liegenden Substrats verringert, falls die Dichte des Haftregulierers (A) geringer ist als die der Siliconzusammensetzung. Ist in diesem Fall die Dichte des Haftregulierers (A) höher als die der Siliconzusammensetzung, wird die Haftkraft zum unteren Substrat gemindert. Dabei ist es von Vorteil, wenn beispielsweise das Trennmittel eine höhere Dichte und der Haftvermittler eine niedrigere Dichte besitzt als die Siliconzusammensetzung. Als minimaler Dichteunterschied zwischen Haftregulierer (A) und der Siliconzusammensetzung werden etwa 0,10 g/cm3 angesehen.

Die Dichte des Klebers wird durch Art und Menge eines ggf. enthaltenen Füllstoffs maßgeblich verändert (im Allgemeinen erhöht). Falls es sich dabei um sehr feinteilige Füllstoffe handelt, so führt die durch den Füllstoff verursachte Dichteänderung tatsächlich zu einem veränderten Haftungsverhalten. Handelt es sich hingegen um sehr grobteilige Füllstoffe, so bewirken diese zwar eine makroskopische Dichteänderung, ohne jedoch das, auf dem Dichteunterschied zwischen den fluiden Bestandteilen der Siliconzusammensetzung und dem Haftregulierer (A), beruhende Haftungsverhalten signifikant zu beeinflussen. Ohne den Schutzumfang hiermit einzuschränken, kann die Grenze zwischen in diesem Sinne feinteiligen bzw. grobteiligen Füllstoffen bei einem mittleren Teilchendurchmesser von etwa 1 µm gezogen werden.

Des Weiteren können ggf. enthaltene Füllstoffe das dem Haftungsverhalten zugrunde liegende Migrationsverhalten des Haftregulierers (A) dadurch beeinflussen, dass diese den Haftregulierer (A) an der Füllstoffoberfläche adsorbieren oder absorbieren. Dieser unerwünschte Effekt kann jedoch durch Auswahl geeigneter Füllstoffe vermieden werden.

Die beschriebenen Siliconzusammensetzungen können optional alle weiteren Zusatzstoffe enthalten, die auch bisher zur Herstellung von vernetzbaren Siliconzusammensetzungen eingesetzt wurden. Beispiele für verstärkende Füllstoffe, die als Komponente in den erfindungsgemäßen Siliconzusammensetzungen eingesetzt werden können, sind pyrogene oder gefällte Kieselsäuren mit BET-Oberflächen von mindestens 50 m²/g sowie Ruße und Aktivkohlen wie Furnace-Ruß und Acetylen-Ruß, wobei pyrogene und gefällte Kieselsäuren mit BET-Oberflächen von mindestens 50 m²/g bevorzugt sind. Die genannten Kieselsäurefüllstoffe können hydrophilen Charakter haben oder nach bekannten Verfahren hydrophobiert sein. Beim Einmischen hydrophiler Füllstoffe ist die Zugabe eines Hydrophobierungsmittels erforderlich. Der Gehalt der erfindungsgemäßen vernetzbaren Zusammensetzung an aktiv verstärkendem Füllstoff liegt im Bereich von 0 bis 70 Gew.-%, vorzugsweise bei 0 bis 50 Gew.-%.

Die erfindungsgemäße Siliconzusammensetzung kann wahlweise als Bestandteile weitere Zusätze zu einem Anteil von bis zu 70 Gew.-%, vorzugsweise 0,0001 bis 40 Gew.-%, enthalten. Diese Zusätze können z.B. inaktive Füllstoffe, harzartige Polyorganosiloxane, die von den vernetzenden Polysiloxanen verschieden sind, verstärkende und nicht verstärkende Füllstoffe, Fungizide, Duftstoffe, rheologische Additive, Korrosionsinhibitoren, Oxidationsinhibitoren, Lichtschutzmittel, flammabweisend machende Mittel und Mittel zur Beeinflussung der elektrischen Eigenschaften, Dispergierhilfsmittel, Lösungsmittel, Pigmente, Farbstoffe, Weichmacher, organische Polymere, Hitzestabilisatoren usw. sein. Hierzu zählen Zusätze wie Quarzmehl, Diatomeenerde,

Tone, Talk, Kreide, Lithopone, Ruße, Graphit, Metalloxide, Metallcarbonate, -sulfate, Metallsalze von Carbonsäuren, Metallstäube, Fasern, wie Glasfasern, Kunststoffasern, Kunststoffpulver, Farbstoffe, Pigmente usw.

Diese Füllstoffe können zudem wärmeleitend oder elektrisch leitend sein. Beispiele für wärmeleitende Füllstoffe sind Aluminiumnitrid; Aluminumoxid; Bariumtitanat; Berylliumoxid; Bornitrid; Diamant; Grafit; Magnesiumoxid; partikuläres Metall wie beispielsweise Kupfer, Gold, Nickel oder Silber; Siliziumcarbid; Wolframcarbid; Zinkoxid und eine Kombination davon. Wärmeleitende Füllstoffe sind im Stand der Technik bekannt und im Handel erhältlich. Zum Beispiel CB-A20S und Al-43-Me sind Aluminiumoxid-Füllstoffe in verschiedenen Partikelgrößen, die im Handel bei Showa-Denko erhältlich sind, und AA-04, AA-2 und AAl 8 sind Aluminiumoxid-Füllstoffe, die im Handel bei Sumitomo Chemical Company erhältlich sind. Silber-Füllstoffe sind im Handel bei Metalor Technologies U.S.A. Corp. of Attleboro, Massachusetts, U.S.A., erhältlich. Bornitrid-Füllstoffe sind im Handel bei Advanced Ceramics Corporation, Cleveland, Ohio, U.S.A., erhältlich. Zu den Verstärkungsfüllstoffen gehören Silica und Kurzfasern wie beispielsweise KEVLAR-Kurzfaser®. Es können eine Kombination aus Füllstoffen mit verschiedenen Partikelgrößen und unterschiedlicher Partikelgrößenverteilung verwendet werden.

Der Kleber kann weiterhin eine oder mehrere optionale Komponenten enthalten, vorausgesetzt, die optionale Komponente hat keine nachteilige Auswirkung auf das Aushärten der Kleberformulierung während des Verfahrens der vorliegenden Erfindung. Zu den Beispielen für optionale Komponenten gehören unter anderem ein oder mehrere Lösungsmittel, ein oder mehrere Inhibitoren, Spacer.

Enthält der Kleber Lösungsmittel ist darauf zu achten, dass das Lösemittel keine nachteiligen Effekte auf das Gesamtsystem hat. Geeignete Lösungsmittel sind im Stand der Technik bekannt und im Handel erhältlich. Das Lösungsmittel kann beispielsweise ein organisches Lösungsmittel mit 3 bis 20 Kohlenstoffatomen sein. Zu den Beispielen für Lösungsmittel gehören aliphatische Kohlenwasserstoffe wie Heptan, Octan, iso-Octane, Nonan, Decan, Undecan und Dodecan; aromatische Kohlenwasserstoffe wie beispielsweise Mesitylen, Xylen und Toluen; Ester wie beispielsweise Ethylacetat und Butyrolacton; Ether wie beispielsweise n-Butylether und Polyethylenglycolmonomethylether; Ketone wie beispielsweise Methylisobutylketon und Methylpentylketon; Siliconfluid wie beispielsweise lineare, verzweigte und zyklische Polydimethylsiloxane und Kombinationen aus diesen Lösungsmitteln. Die optimale Konzentration eines bestimmten Lösungsmittels in einer Kleberformulierung kann durch Routineversuche leicht bestimmt werden. Je nach Gewicht der Verbindung kann die Menge des Lösungsmittels zwischen 0 und 95 % bzw. zwischen 1 und 95 % liegen.

Sind Inhibitoren und Stabilisatoren enthalten so dienen sie der gezielten Einstellung der Verarbeitungszeit, Anspringtemperatur und Vernetzungsgeschwindigkeit der erfindungsgemäßen Siliconzusammensetzungen. Diese Inhibitoren und Stabilisatoren sind auf dem Gebiet der additionsvernetzenden Zusammensetzungen sehr gut bekannt. Beispiele gebräuchlicher Inhibitoren sind acetylenische Alkohole, wie 1-Ethinyl-1-cyclohexanol, 2-Methyl-3-butin-2-ol und 3.5-Dimethyl-1-hexin-3-ol, 3-Methyl-1-dodecin-3-ol, Polymethylvinylcyclosiloxane wie 1,3,5,7-Tetravinyltetramethyltetracyclosiloxan, niedermolekulare Siliconöle mit Methylvinyl-SiO_{1/2}-Gruppen und/oder R₂vinylSiO_{1/2}-Endgruppen, wie Divinyltetramethydisiloxan Tetravinyldimethyldisiloxan, Trialkylcyanurate, Alkylmaleate, wie Diallylmaleate, Dimethylmaleat und Diethylmaleat, Alkylfumarate, wie Diallylfumarat und Diethylfumarat, organische Hydroperoxide wie Cumolhydroperoxid, tert-Butylhydroperoxid und Pinanhydroperoxid, organische Peroxide, organische Sulfoxide organische Amine, Diamine und Amide, Phosphane und Phosphite, Nitrile, Triazole, Diaziridine und Oxime. Die Wirkung dieser Inhibitorzusätze hängt von ihrer chemischen Struktur ab, so dass die Konzentration individuell bestimmt werden muss. Inhibitoren und Inhibitormischungen werden vorzugsweise in einem Mengenanteil von 0,00001 % bis 5 % bezogen auf das Gesamtgewicht der Mischung zugesetzt, bevorzugt 0,00005 bis 2 % und besonders bevorzugt 0,0001 bis 1 %.

Falls Spacer enthalten sind, können sie aus organischen Partikeln, anorganischen Partikeln oder aus einer Kombination davon bestehen. Spacer können wärmeleitend, elektrisch leitend oder beides sein. Spacer können eine Partikelgröße von mindestens 25 bis zu 250 Mikrometer haben. Spacer können monodisperse Kügelchen enthalten. Beispiele für Spacer sind unter anderem Polystyren, Glas, perfluorierte Kohlenwasserstoff-Polymere und eine Kombination davon. Spacer können zusätzlich oder anstatt des Füllstoffs oder Teilen davon hinzugefügt werden.

Die erfindungsgemäße Verwendung von vernetzbarem Kleber hat den Vorteil dass er in einem einfachen Verfahren unter Verwendung leicht zugänglicher Ausgangsstoffe und damit wirtschaftlich hergestellt werden kann. Die erfindungsgemäß verwendeten Kleber haben den weiteren Vorteil, dass sie als einkomponentige Formulierung bei 25°C und Umgebungsdruck eine gute Lagerstabilität aufweisen und erst bei erhöhter Temperatur rasch vernetzen. Die erfindungsgemäß verwendeten Kleber haben den Vorteil, dass diese bei zweikomponentiger Formulierung nach Vermischen der beiden Komponenten eine vernetzungsfähige Siliconmasse ergeben, deren Verarbeitbarkeit über einen langen Zeitraum hinweg bei 25°C und Umgebungsdruck bestehen bleibt, also extrem lange Topfzeit zeigen, und erst bei erhöhter Temperatur rasch vernetzt.

Ein weiterer Gegenstand der Erfindung ist das Verfahren zur temporären Verklebung der beiden chemisch ähnlicher Substrate einem Siliziumwafer mit einem Siliziumträger, dadurch gekennzeichnet, dass
a) ein Kleber auf den Siliziumwafer als Substrat 1 aufgebracht wird,
b) eine Wartezeit von 10 Sekunden bis 120 Minuten eingehalten wird,
c) ein gegebenenfalls enthaltenes Lösungsmittel während der voranstehend genannten Wartezeit b) entfernt wird,
d) der Siliziumträger als Substrat 2 mit dem Kleber in Kontakt gebracht wird,
e) Aushärtung des Klebers erfolgt,
f) Durchführung weiterer Bearbeitungsschritte am der Siliziumträger als Substrat 1 und/oder Siliziumträger als Substrat 2,
g) Trennen der Substrate wobei der ausgehärtete Kleber an einem der beiden Substrate verbleibt,
wobei der Kleber eine vernetzbare Siliconzusammensetzung ist, die dadurch gekennzeichnet ist, dass sie mindestens 0,01 bis 10 Gew. % eines Haftregulierers (A) enthält, der ein Trennmittel ausgewählt aus der Gruppe der
- Fettsäureester die zwischen 10 und 60 C-Atome enthalten, mit der Maßgabe, dass
- die Dichte (p_{HR}) des Haftregulierers (A) mindestens einen Dichteunterschied von 0,10 g/cm3 verglichen mit der Dichte (p_{S}) der Siliconzusammensetzung aufweist und somit
- die Haftkraft zwischen dem ausgehärteten Kleber und einem Substrat um mindestens 0,5 N/mm größer ist als die Haftkraft zwischen dem ausgehärteten Kleber und dem anderen Substrat, gemessen nach **DIN ISO 813,**
- und sich der ausgehärtete Kleber beim Lösen der Verklebung nur von einem Substrat auf mindestens 80 % der Fläche adhäsiv lösen lässt.

In einer bevorzugten Ausführungsform ist Substrat 1 ein Siliziumwafer und Substrat 2 ein Siliziumträger und
- wenn (p_{HR}) kleiner als (p_{S}) ist, die Haftung zum oben liegenden Substrat verringert wird und
- wenn (p_{HR}) größer als (p_{S}) ist, die Haftung zum unten liegenden Substrat verringert wird..

Die erfindungemäßen Kleber weisen im unvulkanisierten Zustand eine Viskosität zwischen 0,01 und 50 Pa•s auf.

Die Massendifferenz des Klebers beträgt in der thermogravimetrischen Analyse (TGA) bei einer Aufheizrate von 10 K / min bis 300 °C höchstens 0,5 Gew %.

Ein Normprüfkörper des gehärteten Klebers mit einer Dicke von 6 mm der Klebstoffformulierung weist eine Shore A Härte zwischen 10 und 95, bevorzugt zwischen 30 und 90 und besonders bevorzugt zwischen 40 und 80 auf.

Falls notwendig, kann der elektrische Widerstand des ausgehärteten Klebers durch geeignete Zusätze verringert werden, um eine elektrostatische Aufladung und Entladung beim Delaminieren zu vermeiden. Hierzu können die dem Stand der Technik entsprechenden Antistatika und leitfähigkeitserhöhenden Additive verwendet werden. Der spezifische elektrische Widerstand des verwendeten ausgehärteten Klebers beträgt bei Raumtemperatur weniger als 1*10¹⁵ Ω cm, vorzugsweise weniger als 1*10¹⁴ Ω cm.

Die dynamische Viskosität des ungehärteten Klebers beträgt bei Raumtemperatur und einer Scherrate von 1 s⁻¹ zwischen 50 und 10000 mPa•s beträgt.

Das Verhältnis der dynamischen Viskosität des verwendeten ungehärteten Klebers bei den Scherraten 1 s⁻¹ und 100 s⁻¹ bei Raumtemperatur ist kleiner als 3, bevorzugt kleiner als 2 und besonders bevorzugt kleiner als 1,2.

Ein Vorteil der verwendeten Kleber ist, dass sie mit gängigen Techniken geschliffen werden können.

## Patentansprüche

1. Verwendung eines Klebers für ein temporäres Verkleben eines Siliziumwafers mit einem Siliziumträger,
wobei der Kleber eine vernetzbare Siliconzusammensetzung ist, die **dadurch gekennzeichnet ist, dass** sie mindestens 0,01 bis 10 Gew. % eines Haftregulierers (A) enthält, der ein Trennmittel ist ausgewählt aus der Gruppe der
- Fettsäureester, die zwischen 10 und 60 C-Atome enthalten, mit der Maßgabe, dass
- die Dichte (p_{HR}) des Haftregulierers (A) mindestens einen Dichteunterschied von 0,10 g/cm³ verglichen mit der Dichte (pₛ) der Siliconzusammensetzung aufweist und somit
- die Haftkraft zwischen dem ausgehärteten Kleber und einem Substrat um mindestens 0,5 N/mm größer ist als die Haftkraft zwischen dem ausgehärteten Kleber und dem anderen Substrat, gemessen nach **DIN ISO 813,**
- und sich der ausgehärtete Kleber beim Lösen der Verklebung nur von einem Substrat auf mindestens 80 % der Fläche adhäsiv lösen lässt, und
- wenn (p_{HR}) kleiner als (pₛ) ist, die Haftung zum oben liegenden Substrat verringert wird und
- wenn (p_{HR}) größer als (pₛ) ist, die Haftung zum unten liegenden Substrat verringert wird.

2. Verwendung eines Klebers nach Anspruch 1, wobei die vernetzbare Siliconzusammensetzung ausgewählt wird aus der Gruppe enthaltend kondensationsvernetzende, additionsvernetzende und peroxidisch vernetzende Siliconzusammensetzungen.

3. Verfahren zur temporären Verklebung der beiden chemisch ähnlichen Substrate einem Siliziumwafer mit einem Siliziumträger, **dadurch gekennzeichnet, dass**
a) ein Kleber auf den Siliziumwafer als Substrat 1 aufgebracht wird,
b) eine Wartezeit von 10 Sekunden bis 120 Minuten eingehalten wird,
c) ein gegebenenfalls enthaltenes Lösungsmittel während der voranstehend genannten Wartezeit b) entfernt wird,
d) der Siliziumträger als Substrat 2 mit dem Kleber in Kontakt gebracht wird,
e) Aushärtung des Klebers erfolgt,
f) Durchführung weiterer Bearbeitungsschritte am Siliziumwafer als Substrat 1 und/oder Siliziumträger als Substrat 2,
g) Trennen der Substrate, wobei der ausgehärtete Kleber an einem der beiden Substrate verbleibt,
wobei der Kleber eine vernetzbare Siliconzusammensetzung ist, die **dadurch gekennzeichnet ist, dass** sie mindestens 0,01 bis 10 Gew.% eines Haftregulierers (A) enthält, der ein Trennmittel ist ausgewählt aus der Gruppe der
- Fettsäureester die zwischen 10 und 60 C-Atome enthalten, mit der Maßgabe, dass
- die Dichte (p_{HR}) des Haftregulierers (A) mindestens einen Dichteunterschied von 0,10 g/cm3 verglichen mit der Dichte (pₛ) der Siliconzusammensetzung aufweist und somit
- die Haftkraft zwischen dem ausgehärteten Kleber und einem Substrat um mindestens 0,5 N/mm größer ist als die Haftkraft zwischen dem ausgehärteten Kleber und dem anderen Substrat, gemessen nach **DIN ISO 813,**
- und sich der ausgehärtete Kleber beim Lösen der Verklebung nur von einem Substrat auf mindestens 80 % der Fläche adhäsiv lösen lässt, und
- wenn (p_{HR}) kleiner als (pₛ) ist, die Haftung zum oben liegenden Substrat verringert wird und
- wenn (p_{HR}) größer als (pₛ) ist, die Haftung zum unten liegenden Substrat verringert wird.

4. Verfahren zur temporären Verklebung zweier chemisch ähnlicher Substrate gemäß Anspruch 3, wobei die vernetzbare Siliconzusammensetzung ausgewählt wird aus der Gruppe enthaltend kondensationsvernetzende, additionsvernetzende und peroxidisch vernetzende Siliconzusammensetzungen.

## Claims

1. Use of an adhesive for temporary adhesive bonding of a silicon wafer to a silicon support,
the adhesive being a crosslinkable silicone composition which is **characterized in that** it comprises at least 0.01 to 10 wt% of an adhesion regulator (A) which is a release agent selected from the group of
- fatty acid esters which contain between 10 and 60 carbon atoms,
with the proviso that
- the density (p_{HR}) of the adhesion regulator (A) has at least a density difference of 0.10 g/cm³ as compared with the density (pₛ) of the silicone composition and thus
- the adhesive force between the cured adhesive and the one substrate is greater by at least 0.5 N/mm than the adhesive force between the cured adhesive and the other substrate, measured according to **DIN ISO 813,**
- and the cured adhesive can be parted adhesively on at least 80% of the area only from one substrate on parting of the bond, and
- if (p_{HR}) is smaller than (pₛ), the adhesion to the top substrate is reduced and
- if (p_{HR}) is greater than (pₛ), the adhesion to the bottom substrate is reduced.

2. Use of an adhesive according to Claim 1, the crosslinkable silicone composition being selected from the group containing condensation-crosslinking, addition-crosslinking, and peroxidically crosslinking silicone compositions.

3. Method for the temporary adhesive bonding of the two chemically similar substrates of a silicon wafer to a silicon support, **characterized in that**
a) an adhesive is applied to the silicon wafer as substrate 1,
b) a waiting time of 10 seconds to 120 minutes is observed,
c) any solvent present is removed during the aforementioned waiting time b),
d) the silicon support as substrate 2 is contacted with the adhesive,
e) curing of the adhesive takes place,
f) implementation of further working steps on the silicon wafer as substrate 1 and/or silicon support as substrate 2,
g) separation of the substrates, with the cured adhesive remaining on one of the two substrates, the adhesive being a crosslinkable silicone composition which is **characterized in that** it comprises at least 0.01 to 10 wt% of an adhesion regulator (A) which is a release agent selected from the group of
- fatty acid esters which contain between 10 and 60 carbon atoms,
with the proviso that
- the density (p_{HR}) of the adhesion regulator (A) has at least a density difference of 0.10 g/cm³ as compared with the density (pₛ) of the silicone composition and thus
- the adhesive force between the cured adhesive and the one substrate is greater by at least 0.5 N/mm than the adhesive force between the cured adhesive and the other substrate, measured according to **DIN ISO 813,**
- and the cured adhesive can be parted adhesively on at least 80% of the area only from one substrate on parting of the bond, and
- if (p_{HR}) is smaller than (pₛ), the adhesion to the top substrate is reduced and
- if (p_{HR}) is greater than (pₛ), the adhesion to the bottom substrate is reduced.

4. Method for the temporary adhesive bonding of two chemically similar substrates according to Claim 3, the crosslinkable silicone composition being selected from the group containing condensation-crosslinking, addition-crosslinking, and peroxidically crosslinking silicone compositions.

## Revendications

1. Utilisation d'un adhésif pour un collage temporaire d'une plaquette de silicium avec un support de silicium,
l'adhésif étant une composition de silicone réticulable, qui est **caractérisée en ce qu'**elle contient au moins 0,01 à 10 % en poids d'un régulateur d'adhérence (A), qui est un agent anti-adhérent choisi dans le groupe constitué par
- les esters d'acides gras qui contiennent entre 10 et 60 atomes C,
à condition que
- la densité (p_{HR}) du régulateur d'adhérence (A) présente au moins une différence de densité de 0,10 g/cm³ en comparaison de la densité (pₛ) de la composition de silicone, et ainsi
- la force d'adhérence entre l'adhésif durci et un substrat est supérieure d'au moins 0,5 N/mm à la force d'adhérence entre l'adhésif durci et l'autre substrat, mesurée selon DIN ISO 813,
- et l'adhésif durci peut être décollé d'un substrat sur au moins 80 % de la surface lors du décollement du collage, et
- lorsque (p_{HR}) est inférieure à (pₛ), l'adhérence au substrat supérieur est réduite, et
- lorsque (p_{HR}) est supérieure à (pₛ), l'adhérence au substrat inférieur est réduite.

2. Utilisation d'un adhésif selon la revendication 1, dans laquelle la composition de silicone réticulable est choisie dans le groupe contenant les compositions de silicone réticulant par condensation, réticulant par addition et réticulant au peroxyde.

3. Procédé de collage temporaire des deux substrats chimiquement semblables d'une plaquette de silicium avec un support de silicium, **caractérisé en ce que**
a) un adhésif est appliqué sur la plaquette de silicium en tant que substrat 1,
b) un temps d'attente de 10 secondes à 120 minutes est observé,
c) un solvant éventuellement contenu est éliminé pendant le temps d'attente b) susmentionné,
d) le support de silicium en tant que substrat 2 est mis en contact avec l'adhésif,
e) le durcissement de l'adhésif a lieu,
f) des étapes de traitement supplémentaires sont réalisées sur la plaquette de silicium en tant que substrat 1 et/ou le support de silicium en tant que substrat 2,
g) les substrats sont séparés, l'adhésif durci restant sur un des deux substrats,
l'adhésif étant une composition de silicone réticulable, qui est **caractérisée en ce qu'**elle contient au moins 0,01 à 10 % en poids d'un régulateur d'adhérence (A), qui est un agent anti-adhérent choisi dans le groupe constitué par
- les esters d'acides gras qui contiennent entre 10 et 60 atomes C,
à condition que
- la densité (p_{HR}) du régulateur d'adhérence (A) présente au moins une différence de densité de 0,10 g/cm³ en comparaison de la densité (pₛ) de la composition de silicone, et ainsi
- la force d'adhérence entre l'adhésif durci et un substrat est supérieure d'au moins 0,5 N/mm à la force d'adhérence entre l'adhésif durci et l'autre substrat, mesurée selon DIN ISO 813,
- et l'adhésif durci peut être décollé d'un substrat sur au moins 80 % de la surface lors du décollement du collage, et
- lorsque (p_{HR}) est inférieure à (pₛ), l'adhérence au substrat supérieur est réduite, et
- lorsque (p_{HR}) est supérieure à (pₛ), l'adhérence au substrat inférieur est réduite.

4. Procédé de collage temporaire de deux substrats chimiquement semblables selon la revendication 3, dans lequel la composition de silicone réticulable est choisie dans le groupe contenant les compositions de silicone réticulant par condensation, réticulant par addition et réticulant au peroxyde.
